# EUROPÄISCHE PATENTSCHRIFT

(11) **EP 0 748 395 B1**
(45) Veröffentlichungstag und Bekanntmachung des Hinweises auf die Patenterteilung: **10.09.1997**
(21) Anmeldenummer: 95911214.5
(22) Anmeldetag: 03.03.1995
(51) Int. Cl.: C23C 14/06, C23C 14/00

(54) **VERFAHREN ZUR HERSTELLUNG VON SCHICHTEN AUS KUBISCHEM BORNITRID**
PROCESS FOR PRODUCING LAYERS OF CUBIC BORON NITRIDE
PROCEDE DE FABRICATION DE COUCHES DE NITRURE DE BORE CUBIQUE

(30) Priorität: 04.03.1994 DE 4407274
(43) Veröffentlichungstag der Anmeldung: 18.12.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: LÜTHJE, Holger, Dipl.-Ing., 25469 Halstenbek (DE); BEWILOGUA, Klaus, Dr., 38110 Braunschweig (DE); DAAUD, Simone, Dipl.-Ing., 38122 Braunschweig (DE)
(86) Internationale Anmeldenummer: DE9500315
(87) Internationale Veröffentlichungsnummer: WO9523879

(56) Entgegenhaltungen:
- DIAMOND AND RELATED MATERIALS, Bd. 2, 1993 CH, Seiten 512-516, XP 000361193 N. TANABE ET AL 'Influence of sputtering target material on the formation of cubic BN thin films by ion beam enhanced deposition' in der Anmeldung erwähnt
- JAPANESE JOURNAL OF APPLIED PHYSICS, PART 2 (LETTERS), JULY 1990, JAPAN, Bd. 29, Nr. 7, ISSN 0021-4922, Seiten L1175-L1177, MIENO M ET AL 'Preparation of cubic boron nitride films by RF sputtering'

## Beschreibung

Die Erfindung bezieht sich auf das Gebiet der Herstellung verschleißfester Schichten bzw. der Herstellung von Schichten mit bestimmten Verschleißeigenschaften. Sie betrifft ein Verfahren zur Herstellung von verschleißfesten Schichten aus kubischem Bornitrid (cBN) oder Verbindungsschichten mit einem hohen cBN-Anteil.

Das thermodynamisch nicht stabile cBN zeichnet sich durch eine hohe, nur von Diamant übertroffene Härte aus und besitzt weitere Eigenschaften, die denen von Diamant ähnlich sind. Hierzu zählen insbesondere die gute thermische Leitfähigkeit, die hervorragenden tribologischen Eigenschaften und nicht zuletzt die gute Transparenz im Sichtbaren (n = 2.2), sowie ein extrem großer Bandabstand von >6,4 eV, wodurch cBN auch als Halbleitermaterial ein hohes Potential besitzt.

Im Bereich der Fertigungstechnik hat cBN im Vergleich zu Diamant den essentiellen Vorteil, daß es gegenüber Stahl inert ist und somit die Bearbeitung von eisenhaltigen Werkstücken ermöglicht. Dieser wichtige Produktionsbereich ist Diamantwerkzeugen wegen chemischem Verschleiß des Diamanten nicht zugänglich.

Seit in den 80er Jahren vornehmlich japanische und US-amerikanische Wissenschaftler grundsätzlich nachgewiesen haben, daß die kubische Phase von Bornitrid auch mit Hilfe von plasma-aktivierten Verfahren herstellbar ist, gab es weltweit vielfältige Bemühungen cBN-Schichten herzustellen.

So wird zum Beispiel im "Journal of Applied Physics" 72 (2), 15.07.1992, Seite 504 und im "Journal of Material Research" Vol 8, No. 6, Jun. 1993, die Herstellung von cBN-Schichten beschrieben, wobei eine ionenstrahlunterstützte Aufdampftechnik (IBAD) zur Anwendung gelangte.

Desweiteren wird in "Diamond and Related Materials" 2 (1993), Seite 512 ein Verfahren beschrieben, das mit Hilfe von lonenstrahlkanonen arbeitet, wobei eine lonenquelle zur Zerstäubung der aus Bor oder hexagonalem Bornitrid (hBN) bestehenden Targets eingesetzt wird und eine zweite lonenkanone den Beschuß des auf einem Substrat angelagerten Films übernimmt.

In "Surface and Coating Technology" 43/44 (1990), Seiten 145 - 153 wird darüber hinaus ein reaktives lonplating Verfahren beschrieben, bei dem man Bor mit Hilfe eines Elektronenstrahlverdampfers in einer Ar/N₂-Atmosphäre, die zusätzlich ionisiert wird, verdampft. Die sich bildende Schicht liegt auf einem Substrathalter mit negativem Potential, so daß die wachsende Schicht mit den vorhandenen Ar und N₂-lonen beschossen wird.

Bei dem in "Thin Solid Films" 224 (1993), Seiten 46 - 51 beschriebenen Verfahren erfolgt die Herstellung der cBN-Schichten mit Hilfe eines lonen-unterstützten Laser-Puls-Verfahrens. Dabei wird ein hBN-Target benutzt. Der lonenbeschuß erfolgt durch Anlegen eines Gleichspannungspotentials.

Das in "Japanese Joumal of Applied Physics" Vol.- 30, No. 2, Febr. 1991, Seiten 344 - 348 beschriebene Verfahren arbeitet mit einer Mikrowellen-Elektron-Zyklotron-Resonanz (EZR)-Abscheidung, wobei BN aus der Gasphase Ar/N₂/B₂H₆ gebildet wird und an das Substrat eine HF-Bias (Hochfrequenz-Vorspannung) gelegt wird.

Schließlich ist noch im "Japanese Joumal of Applied Physics" Vol. 29, No. 7, July 1990, Seiten 1175 - 1177 ein Verfahren zur Herstellung von cBN enthaltenden Schichten dargestellt, bei dem ein hBN-Target in einem inerten Hochfrequenzplasma (HF-Plasma) zerstäubt wird. Das Substrat wird ebenfalls mit einem HF-Bias auf negativem Potential gehalten, so daß ein Beschuß mit Ar-lonen erfolgt.

Der Vollständigkeit halber sei auch auf die DE-OS 38 10 237, US-PS 4 412 899, US-PS 4 415 420, US-PS 4 683 043 und US-PS 5 096 740 verwiesen, in denen ebenfalls unterschiedliche Verfahren zur Herstellung von cBN bzw. cBN-enthaltenden Schichten dargestellt sind.

Die im Stand der Technik beschriebenen PVD-Verfahren verwenden einheitlich entweder Bor oder hexagonales Bornitrid (hBN) als Target oder Aufdampfmaterial. Hinsichtlich einer wirtschaftlichen Anwendung besaßen alle diese Verfahren erhebliche Nachteile. So lassen sich mit diesen Verfahren nur relativ kleine Flächen bei geringer Depositionsrate beschichten.

Die bekannten CVD-EZR-Verfahren haben den erheblichen Nachteil, daß die Abscheidung nur bei relativ hohen Substrattemperaturen von > 600°C erfolgen kann. außerdem lassen sich bedingt durch die begrenzte Ausdehnung des EZR-Plasmas, nur verhältnismäßig kleine Substrate beschichten.

In der Hartschichtherstellung allgemein werden heute im wesentlichen PVD-Verfahren angewandt, wobei die Plasmagenerierung aus ökonomischen Gründen mit Hilfe von Gleichstrombogenentladungen (ARC-Verfahren) oder mit Hilfe von mit Gleichstrom betriebenen Magnetron-Katoden erfolgt. Der Gleichstrombetrieb hat neben essentiellen Kostenvorteilen im apperativen Bereich insbesondere auch den Vorteil, daß sich großflächige Beschichtungsanlagen damit realisieren lassen.

Im Hinblick auf die Herstellung von cBN-Schichten bzw. cBN-enthaltenden Schichten haben diese Verfahren den Nachteil, daß die Verwendung elektrisch leitfähiger Ausgangstargets zwingend erforderlich ist und die Herstellung von cBN-Schichten nach dem Stand der Technik nur aus den elektrisch nicht leitfähigen B- bzw. hBN-Ausgangsmaterialien oder einer B₂H₆ enthaltenden Gasphase möglich ist. Somit ist dieses kostengünstige Verfahren nach dem Stand der Technik zur Herstellung von cBN-Schichten nicht einsetzbar.

Die Aufgabe der Erfindung, die beinhaltet ein Verfahren zur Herstellung von harten und verschleißfesten cBN-Schichten bzw. cBN enthaltenden Schichten vorzuschlagen, das sämtliche Nachteile des Standes der Technik nicht aufweist, besteht somit darin, ein Verfahren der genannten Art anzugeben, das neben einer hohen Beschichtungsrate auch die Abscheidung bei geringen Substrattemperaturen erlaubt, das nicht ausschließlich auf kleine Substrate beschränkt ist, und das wirtschaftlich vorteilhaft und kostengünstig betreibbar ist.

Darüber hinaus ist es Aufgabe der Erfindung, ein Verfahren der genannten Art anzugeben, mit dem eine großflächige Beschichtung mit hohen Depositionsraten möglich ist, daß heißt es ist auch Aufgabe der Erfindung, die Voraussetzungen dafür zu schaffen, daß die PVD-Verfahren, bei denen die Plasmagenerierung mit Hilfe von Gleichstrombogenentladungen oder mit Hilfe von mit Gleichstrom betriebenen Magnetronkatoden erfolgt, für die Herstellung von cBN-Schichten bzw. cBN-enthaltenden Schichten anwendbar sind.

Daraus resultierend ist es also Aufgabe der Erfindung ein Ausgangstargetmaterial mit einer elektrisch ausreichenden Leitfähigkeit anzugeben, aus dem cBN-Schichten bzw. cBN-enthaltende Schichten herstellbar sind, sowie die geeigneten Verfahrensparameter hierfür.

Schließlich ist es noch Aufgabe der Erfindung, eine mögliche Anwendung des vorzuschlagenden Verfahrens der genannten Art anzugeben.

Erfindungsgemäß werden die Aufgaben verfahrensseitig, wie in den Ansprüchen 1 bis 16 und anwendungsseitig wie in den Ansprüchen 17 bis 22 beschrieben gelöst.

Überraschenderweise, und es war durchaus nicht zu erwarten, wurde gefunden, daß bei Einhaltung entsprechend gewählter Prozeßbedingungen sich cBN-Schichten bzw. cBN-enthaltende Schichten auch unter Verwendung von Borkarbid (B₄C)-Targets, die ca. 20at% Kohlenstoff enthalten, abscheiden lassen. Vorteilhafterweise sollte vor der eigentlichen Schichtaufbringung eine Targetreinigungsphhase und eine gleichzeitig, durch eine mechanische Blende getrennte lonen-Ätzreinigung der Substrate erfolgen.

Bei dem Verfahren zur Herstellung von verschleißfesten Schichten aus cBN oder cBN-enthaltenden verschleißfesten Schichten mittels PVD- oder ähnlicher Verfahren, bei denen die Plasmagenerierung mit Hilfe von Gleichstrombogenentladungen (ARC-Verfahren) oder mit Hilfe von mit Gleichstrom betriebenen Magnetronkatoden erfolgt, wird erfindungsgemäß ein Ausgangstarget, an dem der Materialabtrag für die Schichtherstellung erfolgt, aus elektrisch leitendem Material eingsetzt. Dieses Target besteht vorzugsweise aus Borcarbid, günstigerweise im Zusammensetzungsbereich von 90at% bis 70at% Bor und 10at% bis 30at% Kohlenstoff (z.B. B₄C). In einer anderen Verfahrensvariante werden als Ausgangstargets mit Metall (z.B. Ti, Mo, Ta, Cr, Cu, Ni und/oder Al) und/oder deren Boride oder Nitride, sofern diese eine gute Leitfähigkeit aufweisen, dotierte B- und/oder BN-Targets eingesetzt. Bei dem erfindungsgemäßen Verfahren erfolgt die reaktive Prozeßführung unter Zugabe von Ar und N₂ derart, daß die erforderliche B:N-Stöchiometrie in der Schicht eingestellt werden kann.

Dabei sollte ganz allgemein die Prozeßführung so erfolgen, daß der Kohlenstoffanteil in der cBN-Schicht bzw. in der cBN-enthaltenden Schicht auf Werte < 5at% reduziert wird. In der vorliegenden Erfindung wird ein reduzierter Einbau von Kohlenstoff in die Schicht und die erforderliche Einstellung des BN-Verhältnisses so gelöst, daß der Prozeß in einer Ar/N₂-Gas-Mischung durchgeführt wird. In Analogie zu Diamant-CVD-Abscheidung wäre zu erwarten gewesen, daß ein erhöhter Sauerstoffgehalt im Arbeitsgas durch selektive Reaktion mit dem Kohlenstoff dessen Anteil in der Schicht reduziert. Es zeigte sich aber, daß für hohe Anteile der kubischen Phase in den Schichten gerade ein niedriger Sauerstoff-Partialdruck günstig ist.

Zur Verbesserung der Haftung der cBN-Schicht bzw. der cBN-enthaltenden Schicht auf dem Substrat sollte vor der eigentlichen cBN-Schicht noch eine Gradientenschicht ohne Unterbrechung des Vakuumprozesses, z.B. durch schrittweise, kontinuierliche Variation der Prozeßgaszusammensetzung und der Prozeßbedingungen, auf dem Substrat abgeschieden werden.

Ganz allgemein hat es sich weiterhin als günstig erwiesen, wenn der Substrathalter vor der Beschichtung mit einer Schicht aus BC/BN (Borcarbid und/oder Bornitrid), vorzugsweise mit einer Dicke von 0,1 bis 0,5 µm, belegt wird.

Für das erfindungsgemäße Verfahren sollte neben anderen existierenden Möglichkeiten zweckmäßigerweise entweder das Hochfrequenz-Sputterverfahren bzw. Aufstäuben oder das Gleichspannungs-(DC)-Magnetronverfahren angewandt werden.

Sollte das Hochfrequenz-Sputterverfahren zur Anwendung gelangen, so ist es empfehlenswert, wenn die Hochfrequenz-Einkopplung auf der Target- und auch auf der Substratseite, oder alternativ hierzu Gleichspannung (DC) auf der Substratseite eingekoppelt wird, wobei mit einer negativen Bias-Spannung (Vorspannung) im Bereich von 100 bis 1.000 V (beispielsweise 300 bis 500 V) gearbeitet wird, erfolgt, am Target eine flächenbezogene Leistung zwischen 3 und 17 W/cm² (z.B. 6 W/cm²) und am Substrat eine flächenbezogene Leistung zwischen 1 und 11 W/cm² (z.B. 2 W/cm²) angelegt wird, die Substrattemperatur auf einer Temperatur im Bereich zwischen 30°C und 500°C (z.B. auf einer Gleichgewichtstemperatur von 350°C) gehalten wird, als Prozeßgas ein Ar/N₂-Gasgemisch, wobei der N₂-Gehalt in dem Gasgemisch 5 % bis nahe 100 % (z.B. 10 bis 70 %) beträgt, eingesetzt wird und der Prozeßdruck im Bereich von 1 bis 50 µbar (z.B.20 µbar) eingestellt wird.

Sollte das Gleichspannungs-Magnetronverfahren mit UBM (unbalanced Magnetron) zur Anwendung gelangen, so ist empfehlenswert, an das Target eine flächenbezogene Leistung von 2 bis 13 W/cm² (z.B. 5 W/cm²) und an das Substrat eine flächenbezogene Leistung von 0,4 bis 8 W/cm² (z.B. 1 W/cm²) anzulegen, den Substrathalter, an den eine Bias-Spannung anzulegen ist, drehbar zu lagern, den Prozeßdruck im Bereich von 1 bis 10 µbar (z.B. 4 µbar) einzustellen und als Prozeßgas eine Ar/N₂-Gasmischung mit N₂-Gehalten zwischen 10 und nahe 100 % (z.B. 50 % Gasfluß), einzusetzen. Bei dieser Variante des erfindungsgemäßen Verfahrens, bei der das Gleichspannungs-Magnetronverfahren angewendet wird, ist es möglich, an den Substrathalter eine Hochfrequenz-Vorspannung (HF-Bias) oder eine Gleichspannungs-Vorspannung anzulegen. Sollte eine Gleichspannungsvorspannung an den Substrathalter angelegt werden, so ist eine Vorspannung von 100 - 800 V von Vorteil, und sollte eine Hochfrequenz-Vorspannung an den Substrathalter angelegt werden, so wäre eine Vorspannung im Bereich von 100 V bis 1.000 V (z.B. von 200 V bis 500 V) vorzugsweise anzulegen.

Zweckmäßigerweise sollte ganz allgemein der Prozeß zusätzlich magnetfeldunterstützt gefahren werden, um somit die Herstellung der gewünschten Schichten zu begünstigen. Sinnvollerweise erfolgt diese Magneffeldunterstützung derart, daß mittels einer im Rezipienten eingebauten Spule Flußdichten von etwa 4 - 7 mT erzielt werden, oder die zusätzliche Magneffeldunterstützung wird erreicht, indem zusätzliche Magneten oder Elektromagnetspulen so eingebaut werden, daß eine maximale lonenstromverdichtung hinsichtlich des Substrates erfolgt.

Das erfindungsgemäße Verfahren ist sehr wirtschaftlich, kostengünstig und weist sämtliche Nachteile des Standes der Technik nicht auf, was seine Anwendung äußerst vorteilhaft werden läßt.

Ein zusätzlicher Vorteil der Verfahrensvarianten Hochfrequenz-Sputterverfahren und Gleichspannungs-Magnetronverfahren ist der, daß die bei diesem Verfahren vorhandene Prozeßwärme ausreichend ist, so daß auf eine externe Beheizung der Proben verzichtet werden kann.

Es sei an dieser Stelle noch angeführt, daß es möglich und für bestimmte Anwendungsfälle vorteilhaft ist, dem Prozeßgasgemisch zusätzlich borhaltige Gase (z.B. Diboran oder Trimethylborazin) zuzuführen, sowie im Verlauf der Schichtherstellung unterschiedliche Temperaturen von 100°C bis 600°C anzuwenden.

Das erfindungsgemäße Verfahren ist vorteilhaft in verschiedenen Anwendungsgebieten einsetzbar. Es wird zum Beispiel vorteilhaft zur Herstellung verschleißfester Werkzeuge (z.B. zur Beschichtung von mechanisch abrasiv und/oder adhesiv beanspruchten Komponenten, wie beispielsweise Wendeschneidplatten, Fräser, Bohrer, Preß- und Umformwerkzeuge, sowie Lager und/oder Lagerbauteilen), zur Herstellung von mit kubischem Bornitrid (cBN) beschichteten Tonabnehmern und Komponenten zur Bandführunug von Magnetbändern, zur Abscheidung von cBN für elektronische Anwendungen, insbesondere zur Herstellung von elektronischen Bauteilen mit und ohne Dotierung, zur Herstellung von Korrosionsschutzschichten und Isolationsschichten und zur Herstellung von optischen Komponenten mit einer Vergütungsschicht und einer Schutzschicht gegen mechanische Beanspruchung angewendet.

Mit der erfindungsgemäßen Lösung ist es somit erstmals möglich, cBN-Schichten aus elektrisch ausreichend leitfähigen borhaltigen Targets herzustellen und somit die Möglichkeit geschaffen, die eingangs genannten, äußerst kostengünstigen und vorteilhaften PVD-Verfahren, wie beispielsweise das Gleichspannungs-Magnetronverfahren, das Hochfrequenz-Sputterverfahren und andere zur Herstellung von cBN-Schichten bzw. cBN-enthaltenden Schichten einzusetzen.

Ganz allgemein sind Schichten, die aus den Komponenten B, C und N bestehen bereits bekannt. Ihr Vorteil besteht u.a. darin, daß sie hohe mechanische Festigkeiten verbunden mit einer guten optischen Transparenz besitzen und damit Vorteile gegenüber den vergleichbar harten amorphen Kohlenwasserstoffschichten zeigen, die aber im sichtbaren Spektralbereich nicht transparent sind. Ein weiterer Vorteil der cBN-Schicht liegt in ihrem geringen Reibwert µ, welcher < 0,2 und vergleichbar mit Diamantschichten ist. Somit besitzen derartige cBN-Schichten sehr gute Gleiteigenschaften, so daß mit ihnen vorteilhaft mechanisch abrasiv und/oder adhesiv beanspruchte Komponenten sowie Lager und/oder Lagerbauteile beschichtet werden können. Bisher ist es aber noch nicht gelungen, in einfacher kostengünstiger Weise in solchen Schichten die harte kubische Phase zu erzeugen. Dabei werden cBN und wBN (Wurtzit-Phase) in gleichwertiger Weise angestrebt. Die beiden Phasen cBN und wBN, deren Dichte identisch ist, sind insofern als gleichwertig anzusehen, als in beiden Modifikationen B- und N-Atome vierfach koordiniert sind und die gleiche Nahordnung vorliegt. Zwischen allen B- und N-Atomen bestehen Einfachbindungen (sp₃-Zustand). Außerdem kann unter der Definition cBN auch ein nanokristallines oder amorphes Material, das eine sp₃ Hybridbindung für die Elemente B und N aufweist, verstanden werden. In der vorliegenden Erfindung sind unter cBN nur die harten Phasen cBN und wBN zu verstehen.

Das erfindungsgemäße Verfahren wird an nachfolgenden Ausführungsbeispielen näher erläutert.

### Ausführungsbeispiele:

Es hat sich gezeigt, daß verschiedene Prozeßführungen zur Herstellung von verschleißfesten Schichten aus kubischem Bornitrid geeignet sind.

In den hier aufgeführten Beispielen erfolgt vor der eigentlichen Schichtaufbringung eine Targetreinigungsphase und eine gleichzeitig, durch eine mechanische Blende (Shutter) getrennte lonen-Ätzreinigung der Substrate. Die Shutter waren in nachfolgenden Ausführungsbeispielen während der Schichtherstellung geöffnet.

Als Substrate kamen Silizium Wafer (Orientierungen 100 und 111) zur Anwendung, sowie Stahlproben aus 100 Cr6, HSS (High Speed Steel), Hartmetalle, Molybdän und Edelstahl.

### 1. HF-Sputterverfahren (Hochfrequenz-Aufstäubungs-Verfahren)

Als besonders vorteilhaft hat sich ein Verfahren erwiesen, bei welchem die Schicht in einer Hochfrequenz-Dioden Sputteranlage hergestellt wird. Hierbei erfolgt die Hochfrequenz-Einkopplung auf der Target- und auch auf der Substratseite, wobei mit negativen Biasspannungen (Vorspannungen) im Bereich von 300 - 500 V gearbeitet wird. Es besteht auch die Möglichkeit, auf der Substratseite Gleichspannung (DC = direct current = Gleichspannung) einzukoppeln. Die erwünschten Eigenschaften der herzustellenden Schichten werden unter Verwendung eines leitfähigen Targets aus B₄C erhalten. Hierfür werden flächenbezogene Leistungen von 6 W/cm² am Target angelegt. Es wird mit Leistungen an der Substratelektrode von 2 W/cm² gearbeitet, wobei sich die Elektroden, mit einem Durchmesser von ca. 170 mm in einem Abstand von etwa 100 mm gegenüberliegen. Die Substratelektrode kann dabei mit B₄C oder anderen B-haltigen Materialien belegt werden. Es kann jedoch auch eine Stahlplatte oder ein anderes Metall zur Anwendung kommen. Zweckmäßigerweise wird der Prozeß magnetfeldunterstützt gefahren, derart, daß mittels einer im Rezipienten eingebauten Spule Flußdichten von etwa 4 bis 7 mT entstehen und somit die Herstellung der erwünschten Schichten begünstigt wird. Eine Beheizung der Proben ist nicht erforderlich. Aufgrund der Prozeßwärme nehmen die Substrate während der Beschichtung eine Gleichgewichtstemperatur von bis zu 350°C an.

Die kubische Bornitridschicht entsteht unter Verwendung von einem Gasgemisch aus Ar und N₂, wobei der Prozeßdruck bei 20 µbar lag. Der N₂-Gehalt in dem Gasgemisch lag in einem Bereich von 50 - 70 % des Gesamtflows. Mit diesem Verfahren wurde eine 0,8 µm dicke cBN-Schicht mit den typischen Eigenschaften der harten kubischen Bornitrid-Phase erhalten.

### 2. DC-Magnetronverfahren (Gleichspannungs-Magnetronverfahren)

Ein weiteres Herstellungsverfahren um verschleißfeste Schichten aus kubischem Bornitrid auf ein Substrat abzuscheiden, ist gemäß der Erfindung gegeben durch die Anwendung von mit einer Gleichspannung betriebenen UBM-Anlage (UBM = unbalanced Magnetron). In diesem Fall kann der Substrathalter sowohl mit einer HF-Bias, als auch mit einer DC-Bias betrieben werden. Es wurde eine kommerzielle Anlage mit einer vertikal angeordneten Magnetronkatode mit Zusatzspulen für einen unbalancierten Sputterbetrieb (UBM) verwandt. Das eingesetzte B₄C Target hatte Abmessungen von 254 mm x 127 mm. Im Abstand von 80 mm bis 150 mm wurde der Substrathalter angeordnet, der aus einer Edelstahlplatte bestand. Der Substrathalter war drehbar, so daß während eines Vakuumzykluses auch Zwischenschichten aufgebracht werden konnten, in dem der Substrathalter vor eine zweite Magnetronkatode gefahren wurde, die um 90° versetzt angeordnet war.

Im Vergleich zum vorhergehenden Ausführungsbeispiel mit Hochfrequenz betriebenen Elektroden werden hier wesentlich höhere Depositionsraten erzielt. Zudem können mit einer derartigen Anlage verhältnismäßig große Substrate beschichtet werden. Zweckmäßigerweise werden zusätzliche Magnetspulen und gegebenenfalls Stabmagneten derart eingebaut, daß eine maximale lonenstromverdichtung hinsichtlich des Substrates erfolgt.

Als Targetmaterial wurde hier B₄C eingesetzt, wobei an das Target eine flächenbezogene Leistung von 5 W/cm² angelegt wurde.

Es wurden die beiden möglichen Varianten (Substrathalter auf Hochfrequenz- oder Gleichspannungs-Vorspannung) mit folgenden Parametern durchgeführt:
- *Substrathalter auf Hochfrequenz-Bias:* In diesem Fall wurde an das Substrat eine Hochfrequenz-Leistung von 300 W angelegt. Hieraus resultiert eine Bias-Spannung von 200 V bis 500 V. Der Substrathalter, in welchen Hochfrequenz eingespeist wird, steht im Abstand von 80 bis 150 mm zum Target. Auch bei diesem Verfahren erfolgte eine zusätzliche Magneffeldunterstützung, indem zusätzliche Magneten derart eingebaut werden, daß eine maximale lonenstromverdichtung hinsichtlich des Substrates erfolgt. Der Prozeßdruck liegt im Bereich von 4·10⁻³ mbar, wobei auch hier mit einer Ar/N₂ Mischung gearbeitet wird. Die N₂-Gehalte liegen bei 80 % (Flow).
- *Substrathalter auf Gleichspannungs-Bias:* Eine Variante des cBN Prozesses besteht darin, die DC-Magnetronanlage auch auf der Substratseite mit Gleichspannung zu betreiben. In diesem Fall besteht der Substrathalter aus Edelstahl oder anderen geeigneten Metallen. Die anderen Einstellungen bleiben gegenüber dem oben beschriebenen HF-Bias Beispiel gleich. Lediglich an den Substrathalter wird eine DC-Biasspannung von 500 V angelegt. Es zeigte sich, daß Beschichtungsdicken von bis zu 6 µm aus hochisolierenden cBN Schichten auf diese Weise herstellbar sind.

Als eine Variante dieses Ausführungsbeispiels wird vor der Beschichtung eine 100 nm bis 1.000 nm dicke Zwischenschicht aus einer leitfähigen Ti B(N) und/oder B₄C Schicht auf den Substrathalter und die darauf montierten Substrate aufgebracht.

Eine vergleichbar leitfähige Schicht kann auch für die Herstellung von noch dickeren cBN Schichten in sehr begrenzter Dicke zwischendurch aufgebracht werden.

Auch bei dem Gleichspannungs-Magnetron Beispiel kann auf eine externe Beheizung der Proben verzichtet werden.

## Patentansprüche

1. Verfahren zur Herstellung von verschleißfesten Schichten aus kubischem Bornitrid oder solches enthaltenden verschleißfesten Schichten durch Aufstäuben mit Hochfrequenz oder mit Gleichspannung in der Betriebsart als unbalanciertes Magnetron, bei der die Plasmaerzeugung mittels Gleichstrombogenentladungen oder gleichstrombetriebenen Magnetronkatoden erfolgt, **dadurch gekennzeichnet,** daß als Ausgangstarget ein Target aus elektrisch leitendem Borcarbid eingesetzt und die Stöchiometrie der Schicht mit reaktiver Prozeßführung unter Zuführung von N₂ und Ar eingestellt wird.

2. Verfahren nach Anspruch 1, **dadurch gekennzeichnet,** daß ein Target aus Borcarbid im Zusammensetzungsbereich von 70 bis 90 Atom-% Bor und 10 bis 30 Atom-% Kohlenstoff eingesetzt wird.

3. Verfahren nach Anspruch 2, **dadurch gekennzeichnet,** daß ein Target aus B₄C eingesetzt wird.

4. Verfahren nach einem oder mehreren der Ansprüche 1 bis 3, **dadurch gekennzeichnet,** daß der Kohlenstoffanteil der abgeschiedenen Schicht auf Werte unterhalb 5 Atom-% reduziert wird.

5. Verfahren nach einem oder mehreren der Ansprüche 1 bis 4, **dadurch gekennzeichnet,** daß zur Haftverbesserung der Schicht aus kubischem Bornitrid eine Grundierung durch schrittweise oder kontinuierliche Änderung der Prozeßgaszusammensetzung und der Prozeßbedingungen ohne Vakuumunterbrechung auf dem Substrat abgeschieden wird.

6. Verfahren nach einem oder mehreren der Ansprüche 1 bis 5, **dadurch gekennzeichnet,** daß der Substrathalter vor der Beschichtung mit einer Schicht aus Borcarbid/Bornitrid im Schichtdickenbereich von 0,1 bis 0,5 µm belegt wird.

7. Verfahren nach einem oder mehreren der Ansprüche 1 bis 6, **dadurch gekennzeichnet,** daß bei Hochfrequenzaufstäubung die Hochfrequenzeinkopplung auf Target- und Substratseite erfolgt, wobei eine negative Vorspannung im Bereich von 100 bis 1.000 V benutzt wird, eine flächenbezogene Leistung zwischen 3 und 17 W/cm² am Target und zwischen 1 und 11 W/cm² am Substrat eingebracht wird, die Substrattemperatur während der Beschichtung im Bereich zwischen 30°C und 500°C gehalten wird, ein Prozeßgas aus einem Ar/N₂-Gasgemisch mit 5 % bis nahe 100 % N₂ eingesetzt und der Prozeßdruck zwischen 1 und 50 µbar eingestellt wird.

8. Verfahren nach Anspruch 7, **dadurch gekennzeichnet,** daß das Substrat mit Gleichspannung versorgt wird.

9. Verfahren nach Anspruch 7 und 8, **dadurch gekennzeichnet,** daß eine flächenbezogene Leistung von 6 W/cm² am Target und von 2 W/cm² am Substrat eingebracht wird, das Substrat während der Beschichtung auf einer Gleichgewichtstemperatur von 350°C gehalten wird, eine Prozeßgasmischung aus Ar und N₂ mit 10 bis 70 % N₂ und ein Prozeßdruck von 20 µbar benutzt werden.

10. Verfahren nach einem oder mehreren der Anspüche 1 bis 6, **dadurch gekennzeichnet,** daß bei Gleichspannungsmagnetronaufstäubung in der Betriebsart als unbalanciertes Magnetron eine flächenbezogene Leistung von 2 bis 13 W/cm² am Target und von 0,4 bis 8 W/cm² am Substrat eingebracht wird, der Substrathalter drehbar gelagert wird, der Prozeßdruck im Bereich von 1 bis 10·µbar liegt, als Prozeßgas eine Ar/N₂-Gasmischung mit 10 bis nahe 100 % N₂ im Bereich zwischen 1 und 10 µbar gehalten wird, und an den Substrathalter entweder eine Vorspannung von 100 - 800 V Gleichspannung oder von 100 bis 1.000 V Hochfrequenzspannung angelegt wird.

11. Verfahren nach Anspruch 10, **dadurch gekennzeichnet,** daß am Target eine flächenbezogene Leistung von 5 W/cm² am Target und von 1 W/cm² am Substrat eingebracht, eine Prozeßgasströmung mit 50 % N₂ und der Prozeßdruck auf 4 µbar eingestellt wird.

12. Verfahren nach einem oder mehreren der Ansprüche 1 bis 11, **dadurch gekennzeichnet,** daß der Prozeß magnetfeldunterstützt betrieben wird, wobei im Rezipienten eine Spule mit Flußdichten von 4 bis 7 mT eingebaut wird.

13. Verfahren nach Anspruch 12, **dadurch gekennzeichnet,** daß eine zusätzliche Magnetfeldunterstützung erreicht wird, wenn zusätzliche Magnete oder Elektromagnetspulen so eingebaut werden, daß eine maximale lonenstromdichte am Substrat erreicht wird.

14. Verfahren nach einem oder mehreren der Ansprüche 1 bis 13, **dadurch gekennzeichnet,** daß dem Prozeßgas borhaltige Gase zugesetzt werden.

15. Verfahren nach Anspruch 14, **dadurch gekennzeichnet,** daß dem Prozeßgas Diboran oder Trimethylborazin zugeführt werden.

16. Verfahren nach einem oder mehreren der Ansprüche 1 bis 15, **dadurch gekennzeichnet,** daß bei der Beschichtung Temperaturen von 100°C bis 600°C angewandt werden.

17. Anwendung des Verfahrens nach einem oder mehreren der Ansprüche 1 bis 16 zur Herstellung verschleißfester Werkzeuge.

18. Anwendung nach Anspruch 17 auf mechanisch abrasiv und/oder adhesiv beanspruchter Komponenten sowie Lager und/oder Lagerbauteilen.

19. Anwendung nach einem oder mehreren der Ansprüche 1 bis 16 zur Herstellung von mit kubischem Bornitrid beschichteten Tonabnehmern und Komponenten zur Bandführung von Magnetbändern.

20. Anwendung nach einem oder mehreren der Ansprüche 1 bis 16 zur Abscheidung von kubischem Bornitrid für elektronische Anwendungen, insbesondere zur Herstellung von elektronischen Bauteilen mit und ohne Dotierung.

21. Anwendung nach einem oder mehreren der Ansprüche 1 bis 16 zur Herstellung von Korrosionsschutzschichten und Isolationsschichten.

22. Anwendung nach einem oder mehreren der Ansprüche 1 bis 16 zur Herstellung von optischen Komponenten mit einer Vergütungsschicht und einer Schutzschicht gegen mechanische Beanspruchung.

## Claims

1. Method of manufacturing wear-resistant layers of cubic boron nitride or wear-resistant layers containing the same, by powdering with high frequency or with direct current in the operational mode as an unbalanced magnetron, in which the plasma is generated by means of DC arc discharges or magnetron cathodes operated by DC, characterised in that there is used as an initial target a target of electrically conductive boron carbide, and the stoichiometry of the layer is set with reactive process guidance with the supply of N₂ and Ar.

2. Method according to claim 1, characterised in that a target is used made of boron carbide in the composition range of 70 to 90atomic% boron and 10 to 30atomic% carbon.

3. Method according to claim 2, characterised in that a target made of B₄C is used.

4. Method according to one or more of claims 1 to 3, characterised in that the carbon content of the deposited layer is reduced to values beneath 5atomic%.

5. Method according to one or more of claims 1 to 4, characterised in that, in order to improve the adhesion of the layer of cubic boron nitride, a base is deposited by staged or continuous alteration of the process gas composition and of the process conditions on the substrate, without interrupting the vacuum.

6. Method according to one or more of claims 1 to 5, characterised in that the substrate carrier is covered, before coating, with a layer of boron carbide/boron nitride in the layer thickness range of 0.1 to 0.5 µm.

7. Method according to one or more of claims 1 to 6, characterised in that, in high frequency powdering, the high frequency coupling is effected on the target and on the substrate side, a negative bias in the range of 100 to 1,000 volts being used, a surface power between 3 and 17 W/cm² being applied to the target and between 1 and 11 W/cm² to the substrate, the substrate temperature being kept during coating in a range between 30°C and 500°C, a process gas of an Ar/N₂ gas mixture with 5% to near 100% N₂ is used, and the process pressure is set between 1 and 50 µbar.

8. Method according to claim 7, characterised in that the substrate is supplied with direct current.

9. Method according to claim 7 and 8, characterised in that a surface power of 6 W/cm² is applied to the target, and of 2 W/cm² to the substrate, the substrate is kept during coating at an equilibrium temperature of 350°C and a process gas mixture of Ar and N₂ with 10 to 70% N₂ and a process pressure of 20 µbar is used.

10. Method according to one or more of claims 1 to 6, characterised in that, in DC magnetron powdering in the mode of operation as an unbalanced magnetron, a surface power of 2 to 13 W/cm² is applied to the target and of 0.4 to 8 W/cm² to the substrate, the substrate carrier is mounted to rotate, the process pressure lies in the range of 1 to 10 µbar, there is used as a process gas an Ar/N₂ gas mixture with 10 to near 100% N₂ in the range between 1 and 10 µbar, and there is applied to the substrate carrier either a bias voltage of 100 - 800 volts DC or from 100 to 1,000 volts of high frequency voltage.

11. Method according to claim 10, characterised in that a surface power of 5 W/cm² is applied to the target and of 1 W/cm² to the substrate, a process gas flow with 50% N₂ and a process pressure of 4 µbar are set.

12. Method according to one or more of claims 1 to 11, characterised in that the process is operated with a reinforced magnetic field, a coil being incorporated in the recipient with flux densities of 4 to 7 mT.

13. Method according to claim 12, characterised in that an additional magnetic field reinforcement is achieved if additional magnets or electromagnetic coils are incorporated so that a maximum ion flow density is achieved on the substrate.

14. Method according to one or more of claims 1 to 13, characterised in that boron-containing gases are added to the process gas.

15. Method according to claim 14, characterised in that diborane or trimethylborazine is added to the process gas.

16. Method according to one or more of claims 1 to 15, characterised in that during coating temperatures of 100°C to 600°C are used.

17. Application of the method according to one or more of claims 1 to 16 to the manufacture of wear-resistant tools.

18. Application according to claim 17 to components subject to mechanical abrasive and/or adhesive stress, and to bearings and/or bearing components.

19. Application according to one or more of claims 1 to 16 for manufacturing sound pick-ups coated with cubic boron nitride and components for guiding the tape of tape recorders.

20. Application according to one or more of claims 1 to 16 for depositing cubic boron nitride for electronic applications, particularly for manufacturing electronic components with and without doping.

21. Application according to one or more of claims 1 to 16 for manufacturing anti-corrosion layers and insulating layers.

22. Application according to one or more of claims 1 to 16 for manufacturing optical components with a blooming layer and a protective layer against mechanical stress.

## Revendications

1. Procédé de fabrication de couches de nitrure de bore résistantes à l'usure ou résistantes à l'usure et contenant celui-ci par pulvérisation à hautes fréquences à tension continue, dans un mode de fonctionnement au magnétron non équilibré, où la création du plasma est effectuée au moyen de décharges en arc à tension continue ou de cathodes de magnétron fonctionnant à tension continue,
caractérisé en ce que
l'on met en oeuvre une cible de carbure de bore à conductivité électrique et en ce que la stoechiométrie de la couche est réglée par conduction réactive du processus en l'alimentant de N₂ et de Ar.

2. Procédé selon la revendication 1,
caractérisé en ce que
l'on met en oeuvre une cible de carbure de bore avec une composition comprise entre 70 et 90 % atomique de bore et 10 à 30 % atomique de carbone.

3. Procédé selon la revendication 2,
caractérisé en ce que
l'on met en oeuvre une cible composée de B₄C.

4. Procédé selon une ou plusieurs des revendications 1 à 3,
caractérisé en ce que
la proportion en carbone de la couche déposée est réduite à des valeurs inférieurs à 5 % atomique.

5. Procédé selon une ou plusieurs des revendications 1 à 4,
caractérisé en ce que
pour améliorer l'adhérence de la couche de nitrure de bore cubique, une couche de base est déposée en modifiant de la composition du gaz process et des conditions du processus par étapes ou en continu, sans interruption du vide.

6. Procédé selon une ou plusieurs des revendications 1 à 5,
caractérisé en ce que
le support de substrat est recouvert avant l'enduction d'une couche de carbure de bore/nitrure de bore d'une épaisseur comprise entre 0,1 et 0,5 µm.

7. Procédé selon une ou plusieurs des revendications 1 à 6,
caractérisé en ce que
lors de la pulvérisation à hautes fréquences, l'alimentation en haute fréquence ait lieu du coté substrat comme du coté cible, où une pré-tension négative comprise entre 100 et 1.000 V est utilisée, qu'une puissance superficielle comprise entre 3 et 17 W/cm² est appliquée à la cible et entre 1 et 11 W/cm² au substrat, que la température du substrat est maintenue à une température comprise entre 30°C et 500°C, qu'un gaz process composé d'un mélange de Ar/N₂ est mis en oeuvre avec 5 % jusqu'à près de 100 % de N₂ et que la pression de procédé réglée est comprise entre 1 et 50 µbar

8. Procédé selon la revendication 7,
caractérisé en ce que
le substrat est alimenté par une tension continue.

9. Procédé selon les revendications 7 à 8,
caractérisé en ce que
est appliquée une puissance superficielle de 6 W/cm² à la cible et de 2 W/cm² au substrat, que pendant l'enduction, la température du substrat est maintenue à une température d'équilibre de 350°C, qu'un mélange de gaz process composé de Ar/N₂ avec 10 % à 70 % de N₂ et qu'une pression de procédé réglée à 20 µbar sont utilisés.

10. Procédé selon une ou plusieurs des revendications 1 à 6,
caractérisé en ce que
lors de la pulvérisation par magnétron à tension continue en mode de fonctionnement au magnétron non équilibré, une puissance superficielle de 2 à 13 W/cm² est appliquée à la cible et entre 0,4 à 8 W/cm² au substrat, que le support de substrat est pivotant, que la pression du procédé est compris entre 1 à 10 µbar, qu'en tant que gaz process, un mélange gazeux de Ar/N₂ avec 10 % jusqu'à près de 100 % de N₂ est maintenu à une pression comprise entre 1 et 10 µbar, et qu'au support de substrat est appliqué soit une pré-tension continue de 100 à 800 V, soit une tension haute fréquence de 100 à 1.000 V.

11. Procédé selon la revendication 10,
caractérisé en ce que
est appliquée une puissance superficielle de 5 W/cm² à la cible et de 1 W/cm² au substrat, qu'est réglé un flux de gaz process avec 50 % de N₂ et une pression du procédé de 4 µbar.

12. Procédé selon une ou plusieurs des revendications 1 à 11,
caractérisé en ce que
le procédé est exploité avec l'aide d'un champ magnétique, où une bobine avec des densités de flux de 4 à 7 mT est insérée dans le récipient.

13. Procédé selon la revendication 12,
caractérisé en ce que
qu'un soutien par champ magnétique supplémentaire est obtenu en ce que des aimants et des bobines d'aimants électrique supplémentaires sont insérés de sorte qu'une densité maximale de faisceau ionique soit obtenue au substrat.

14. Procédé selon une ou plusieurs des revendications 1 à 13,
caractérisé en ce que
l'on ajoute des gaz contenant du bore au gaz process.

15. Procédé selon la revendication 14,
caractérisé en ce que
l'on ajoute du diborane ou du triméthylborazine au gaz process.

16. Procédé selon une ou plusieurs des revendications 1 à 15,
caractérisé en ce que
des températures allant de 100°C jusqu'à 600°C sont appliqués lors de l'enduction.

17. Utilisation du procédé selon une ou plusieurs des revendications 1 à 16 pour la fabrication d'outils résistants à l'usure.

18. Utilisation selon la revendication 17 à des composants soumis à une sollicitation mécanique abrasive et/ou adhésive ainsi qu'à des paliers ou des éléments de paliers.

19. Utilisation du procédé selon une ou plusieurs des revendications 1 à 16 pour la fabrication de têtes de lecture enduites de nitrure de bore cubique (cBN) et de composants de guidage des bandes magnétiques.

20. Utilisation du procédé selon une ou plusieurs des revendications 1 à 16 pour le dépôt de nitrure de bore cubique pour des applications électroniques, en particulier pour la fabrication d'éléments électroniques avec ou sans dopage.

21. Utilisation du procédé selon une ou plusieurs des revendications 1 à 16 pour la fabrication de couches anticorrosion et des couches d'isolation.

22. Utilisation du procédé selon une ou plusieurs des revendications 1 à 16 pour la fabrication de composants optiques munis d'une couche anti-reflets et d'une couche anti-rayures les protégeant contre les sollicitation mécaniques.
